# EUROPEAN PATENT SPECIFICATION

(11) **EP 4 231 358 B1**
(45) Date of publication and mention of the grant of the patent: **22.05.2024**
(21) Application number: 22157298.5
(22) Date of filing: 17.02.2022
(51) Int. Cl.: H01L 29/08, H01L 29/16, H01L 29/167, H01L 29/78, H01L 21/336, H01L 29/24

(54) **TRANSISTOR, POWER ELECTRONIC SWITCHING DEVICE AND METHOD FOR MANUFACTURING A TRANSISTOR**
TRANSISTOR, LEISTUNGSELEKTRONISCHE SCHALTVORRICHTUNG UND VERFAHREN ZUR HERSTELLUNG EINES TRANSISTORS
TRANSISTOR, DISPOSITIF DE COMMUTATION ÉLECTRONIQUE DE PUISSANCE ET PROCÉDÉ DE FABRICATION D'UN TRANSISTOR

(43) Date of publication of application: 23.08.2023
(73) Proprietor: Hitachi Energy Ltd, 8050 Zürich (CH)
(72) Inventor: ALFIERI, Giovanni, 5103 Möriken (CH); ROMANO, Gianpaolo, 5400 Baden (CH); MIHAILA, Andrei, 5415 Rieden (CH)
(74) Representative: Epping - Hermann - Fischer

(56) References cited:
- JP-B2- 3 848 700
- US-A1- 2011 012 133
- US-A1- 2020 286 991

## Description

The present disclosure relates to a transistor, in particular a wide bandgap power transistor, comprising an epitaxial layer, at least one well region and at least one terminal region, in particular a source region. The present disclosure further relates to a power electronic switching device comprising a plurality of switching cells and a method for manufacturing a transistor, in particular a SiC power transistor.

Transistors are used in many applications, including power electronics. It is generally desirable for transistors, such as Metal-Oxide-Semiconductor Field Effect Transistor (MOSFETs), to be able to withstand so-called short-circuit conditions for a specified time. For example, it may be desirable to provide power transistors with a short-circuit withstand time (SCWT) of at least 10 µs. The SCWT may be used by a control circuit to identify a fault in a corresponding power circuit and to de-energize it.

At the same time, it is desirable to minimize conduction losses of transistors, and in particular of power transistors. Low conduction losses generally lead to higher saturation current densities in the semiconductor material, which in turn shortens their SCWT.

Accordingly, it is a challenge to describe improved devices and methods for their manufacturing which allow to balance the aim of low conduction losses with the aim of a predetermined SCWT.

US 2020/286991 A1 relates to a semiconductor device including a trench structure and a manufacturing method. An embodiment of a semiconductor device includes a silicon carbide semiconductor body including source and body regions of opposite conductivity types. A trench structure extends from a first surface into the silicon carbide semiconductor body along a vertical direction, and includes a gate electrode and a gate dielectric. A contact is electrically connected to the source region at the first surface. The source region includes a first source sub-region directly adjoining the contact at a source contact area of the first surface, a second source sub-region, and a third source sub-region. The second sub-region is arranged between the first and third sub-regions along the vertical direction. A doping concentration profile along the vertical direction of the source region includes a doping concentration minimum in the second sub-region and a doping concentration maximum in the third sub-region. Each of the second and third sub-regions overlaps with the source contact area. The semiconductor device may comprise lattice defects in the second source sub-region, wherein the lattice defects reduce the mobility of free charge carriers and furthermore can decrease the effective doping concentration in the second source sub-region by a partial compensation of the donors in the second source sub-region. Exemplary implantation particles for such a mobility reduction and partial counter-doping are argon (Ar), protons, helium (He), resulting for example in Z1/2 defects involving a carbon vacancy. Provision of the lattice defects may provide a further degree of freedom for adjusting a desired bulk resistance of the source region.

Embodiments of the disclosure relate to a transistor, a power electronic switching device and a method for manufacturing a transistor as defined in the attaches set of claims that allow to selectively increase the resistivity inside one of the terminal regions to control a voltage drop within the transistor structure and thus control a corresponding SCWT of the transistor. This is achieved, at least in part, by introduction of at least one resistive region comprising Manganese (Mn) as an amphoteric dopant.

According to a first aspect, a transistor, in particular a wide bandgap semiconductor power transistor as defined in claim 1, is disclosed.

The transistor comprises an epitaxial layer of a first conductivity type, at least one well region of a second conductivity type formed in a selected area of the epitaxial layer, at least one terminal region, in particular a source region, of the first conductivity type formed in or adjacent to the at least one well region, at least one terminal electrode, in particular a source electrode, formed at least partly on a surface of a first part of the at least one terminal region, and at least one resistive region formed within the at least one terminal region, the at least one resistive region comprising amphoteric impurities.

By introducing at least one resistive region formed within at least one terminal region, a resistance of the terminal region can be increased and other parts of the transistor structure can be protected by reducing a voltage drop therein. The use of amphoteric impurities allows to closely control the resistivity of the resistive region and, therefore, the overall resistance of the terminal region. Among others, the inventors have found that the resistivity of a terminal region implanted with amphoteric species can be controlled, for example, based on the implantation dose or an activation temperature of the resistive region.

The at least one resistive region comprise manganese (Mn) as amphoteric dopants. These dopants may operate, selectively, as charge acceptors or donors in common wide bandgap semiconductor materials useful for power electronics, in particular in silicon carbide (SiC), such as 4H-SiC or 6H-SiC.

Using common semiconductor processing steps and parameters, the resistivity of the terminal region can be modulated to lie in excess of 10 Qcm, for example somewhere in the range between 20 Ωcm and 20 kQcm, which is a useful range for controlling the SCWT of a power transistor.

Different structures within the terminal region may be obtained by using various implantation techniques. For example, it is possible to fully separate second sub-regions of the terminal region comprising essentially no amphoteric impurities by one or more first sub-region in which an amphoteric impurity is present. By patterning the at least one terminal region, the current density in different parts of the terminal region can be closely controlled.

The described terminal structure is applicable to many different transistor types, including metal-oxide-semiconductor field-effect transistors (MOSFETs), metal-insulator-semiconductor field-effect transistors (MISFETs), junction field-effect transistors (JFETs) and insulated gate bipolar transistors (IGBTs). Moreover, the described terminal structure can be used in different configurations, including planar and trench configurations.

According to a second aspect, a power electronic switching device as defined in claim 13 is disclosed. The device comprises a plurality of switching cells electrically connected in parallel, wherein each switching cell of the plurality of switching cells comprises a transistor according to the first aspect. By using several of the above transistors in parallel, a relatively high current rating can be obtained, as often required in power electronics.

Features and advantages described in connection with an individual transistor may also be used in more complex devices, such as power electronic switching devices comprising a plurality of transistor cells arranged on a common substrate and/or electrically connected in parallel.

The transistor or power electronic switching devices according to the above aspects may have a voltage rating of 600 Volts or above.

According to a third aspect, a method for manufacturing a transistor, in particular a wide bandgap semiconductor power transistor as defined in claim 14, is provided. The method comprises the steps of:
- epitaxially growing a semiconductor layer of a first conductivity type;
- forming at least one well region of a second conductivity type formed in a selected area of the epitaxial layer;
- forming at least one terminal region, in particular a source region, of the first conductivity type in or adjacent to the at least one well region; and
- implanting an amphoteric dopant in at least a part of the at least one terminal region.

The above steps allow to manufacture a transistor according to the first aspect using well-established processing steps used in the manufacturing of power electrical devices.

For example, an implantation depth of the amphoteric dopant and thus the shape of the resistive region may be controlled using appropriate implantation energies in the range of 50 to 1000 keV.

Moreover, the overall resistivity of the resistive region can be controlled by implanting the amphoteric dopant using an implantation dose in the range of 10¹⁰ cm⁻² to 10¹⁴ cm⁻².

In at least one embodiment, the method further comprises annealing at least one resistive region comprising the implanted amphoteric dopants at a first temperature T₁, wherein the first temperature T₁ is selected based on a target resistivity ρ of the terminal region. According to experiments by the inventors, there is a relationship between an activation temperature and the resistivity of the doped and activated resistive regions, which can be exploited to limit a peak current through the transistor during short-circuit conditions. In particular, if a source region is doped with the amphoteric dopant, a current density in a neighbouring channel region can be reduced, which is defined by the gate-to-source potential (V_{GS}) in power transistors.

The present disclosure comprises several aspects of a semiconductor device, in particular a terminal structure of a transistor, and a method for manufacturing such a transistor and terminal. Every feature described with respect to one of the aspects is also disclosed herein with respect to the other aspects, even if the respective feature is not explicitly mentioned in the context of the specific aspect.

The accompanying figures are included to provide a further understanding. In the figures, elements of the same structure and/or functionality may be referenced by the same reference signs. It is to be understood that the embodiments shown in the figures are illustrative representations and are not necessarily drawn to scale.
Figure 1 shows a schematic cross-section through a terminal region of a transistor.
Figures 2a and 2B shows schematic cross-sections through vertical power transistors in a planar and trench configuration, respectively.
Figures 3 to 9 show various steps of a process for manufacturing a vertical power MOSFET.
Figure 10 shows a relationship between the resistivity of a semiconductor region with amphoteric impurities in dependence on an annealing temperature.
Figures 11 to 13 show different characteristics of a transistor device comprising a resistive region with amphoteric impurities.
Figure 14 shows cross-sections through five potential configurations of a terminal region.
Figure 15 shows perspective views of seven further potential configurations of a terminal region.
Figure 16 shows steps of a method for manufacturing a transistor.

While the disclosed invention is applicable to many different types of semiconductor transistors, a particular focus is placed on power MISFETs, in particular power MISFETs implemented using wide bandgap semiconductor materials, such as SiC. An important feature of a MISFET is the ability to withstand short circuit conditions for a given time, e.g. more than 10 µs. During this time, the so-called short-circuit withstand time (SCWT), associated control circuit can identify and de-energize the fault. In power electronics, SiC MISFETs are typically designed with relatively short channel length and small pitches between neighboring switching cells. Such a compact design is beneficial to minimize conduction losses of individual transistors as well as complex power electronic switching devices. On the other hand, this leads to relatively high saturation current densities which, in turn, shorten the SCWT.

To achieve a desired design trade-off between low conduction losses and a desired SCWT, according to at least one implementation example, a terminal region of a SiC MISFET, for example an n++ source region, is implanted with a high resistive region, in order to obtain a trade-off between conduction losses and SCWT. The resistivity ρ of the high resistive region can be modulated by various processing parameters as described below.

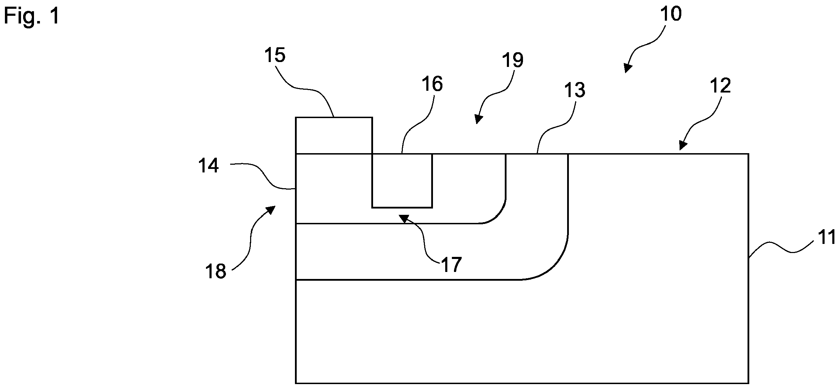

Figure 1 shows an example of such a terminal structure. In particular, it shows a cross-section through part of a transistor 10 comprising an epitaxial layer 11, also referred to as epi-layer 11 or drift layer in the following. The epi-layer 11 may be formed by n-type SiC. In a part of the epi-layer 11 close to its front side or upper surface 12, a well region 13 may be formed by doping the epi-layer 11 with a suitable dopant. For example, a p-well may be formed by selectively doping the epi-layer 11 with an electron accepting element. In the example presented in Figure 1, a channel region of the transistor 10 is located within this well region 13. In a following processing step, a terminal region 14, such as a source region, may be formed in part of the well region 13. The terminal region 14 typically has the same conductivity type as the epi-layer 11, but may have a higher doping concentration. For example, an n++ source region may be formed by implanting dopants acting as electron donors. At least a part of the upper surface 12 of the terminal region 14 is in touch with a terminal electrode 15. For example, a metallization layer may be used to connect an outside terminal to the terminal region 14.

In the described example, the terminal region 14 further comprises a resistive region 16. In the sense of this disclosure, a resistive region has a resistivity that is considerably higher than the remaining parts of the terminal region 14. This is achieved, at least in part, by introduction of amphoteric impurities within the resistive region 16. Since amphoteric impurities can act both as donors and acceptors for charge carriers, it greatly reduces the conductivity of all kinds of doped semiconductor materials, including highly doped p++ or n++ regions of a SiC epi-layer.

The resistive region 16 can take many different configurations. As shown in Figure 1, it may extend from the upper surface 12 partly through the terminal region 14, thereby forming a relatively narrow connecting part 17 connecting a left and right sub-region 18 and 19 of the terminal region 14, respectively. Within the resistive region 16, the depletion of charge carriers by the amphoteric dopant reduces a current. Within the connecting part 17, due to its limited spatial extent, the overall current is also limited. Thus, a short-circuit current flowing through the epi-layer 11, the well region 13, the terminal region 14 and the terminal electrode 15 can be greatly reduced, with most of a corresponding voltage drop occurring within the terminal region 14.

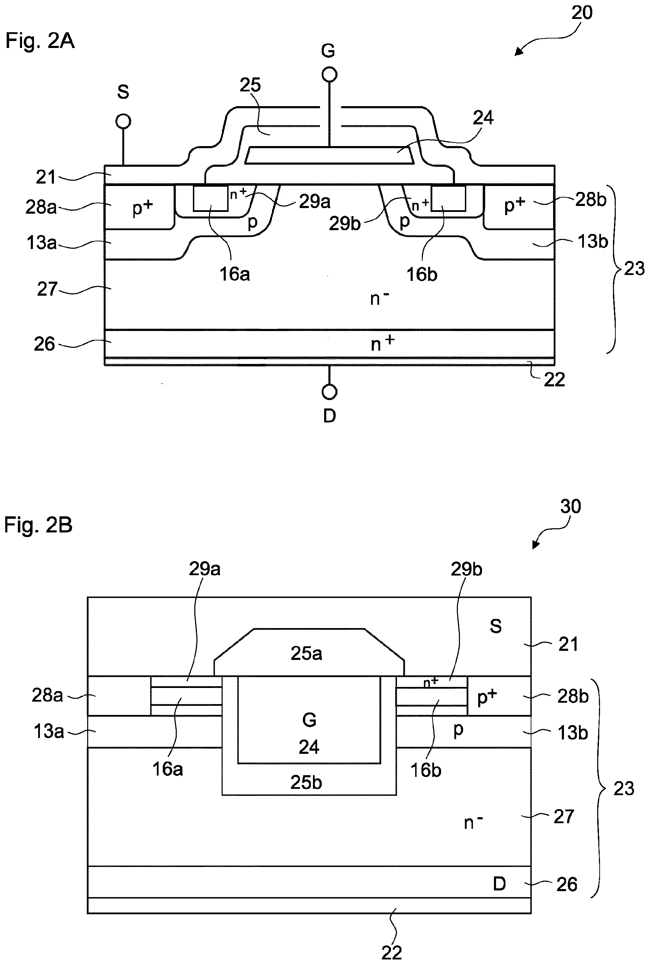

Figure 2A and 2B show how such a terminal electrode can be used in a vertical power transistor.

In particular, Figure 2A shows a modified planar VDMOS 20. The VDMOS 20 comprises a source electrode 21 and a drain electrode 22 arranged on opposite surfaces of a semiconductor transistor structure 23. Between the source electrode 21 and the top surface of the semiconductor transistor structure 23, an insulated gate structure is formed, comprising a gate electrode 24 and surrounding insulation layers 25. The semiconductor transistor structure 23 comprises, from bottom to top, and a n⁺-type substrate layer 26 acting as drain region, an n⁻-type drift layer 27 corresponding to the epi-layer 11 of Fig. 1, an optional n+ buffer layer (not shown) between the substrate layer 26 and the epi-layer 11, two p-type well regions 13a and 13b, two n⁺-type source regions 29a and 29b corresponding to the terminal region 14 of Figure 1, and, in addition, two p⁺-type well contact regions 28a and 28b electrically connecting the source electrode 21 with the well regions 13a and 13b.

In the example presented in Figure 2A, each one of the source regions 29a and 29b comprises a resistive region 16a and 16b as explained above with regard to Figure 1. That is to say, in the modified VDMOS 20 according to Figure 2, the resistivity of both parts of the source regions 29a and 29b is increased and controlled as described above and below.

Figure 2B shows a trench gate power transistor 30 comprising a gate electrode 24 in a trench arranged between two n⁺-type source regions 29a and 29b and p-type well regions 13a and 13b. The gate electrode is insulated by an upper insulation layer 25a from the source electrode 21 and by a lower insulation layer 25b from the semiconductor transistor structure 23. Most other components of the trench gate power transistor 30 correspond to the corresponding parts of the planar VDMOS 20 described above with respect to Figure 2A and are therefore not described here again.

In the example presented in Figure 2B, each one of the source regions 29a and 29b comprises a resistive region 16a and 16b, respectively, configured as a vertical sub-layer of the respective terminal regions 29a and 29b.

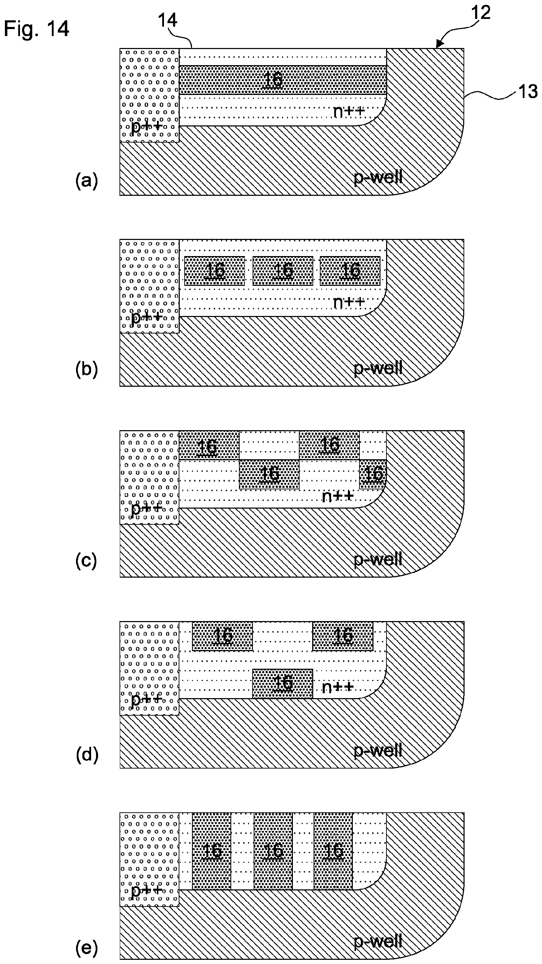

It is noted that the specific configurations of the resistive regions 16a and 16b shown in Figures 2A and 2B are presented as an example, and that other configurations, such as the configurations shown in Figures 14(a) to 15(g) may be used in each of the disclosed transistor devices.

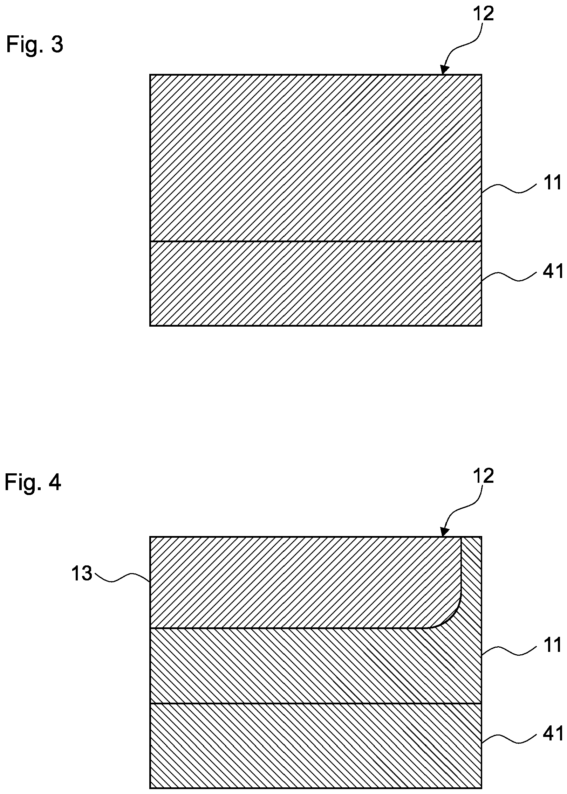

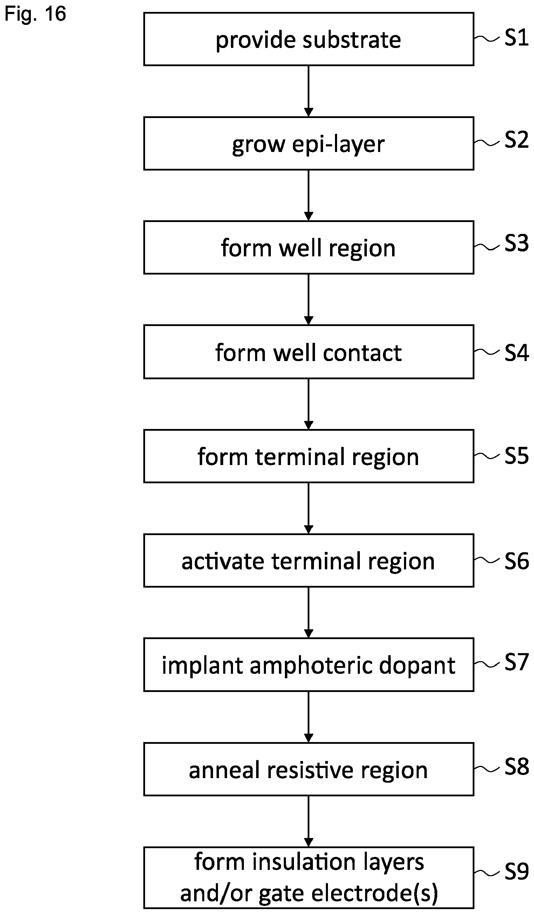

Next, with reference to Figures 3 to 9 as well as the flowchart according to Figure 16, various stages in the manufacturing of a power transistor 40, such as a vertical power MOSFET, will be explained.

Referring first to Figure 3, in a first step S1, a substrate 41 is provided. For example, an n-type SiC substrate may be provided. The substrate 41 may correspond to a backside layer or drain region of the in the finished power transistor 40. For example, Nitrogen (N) or Phosphorus (P) may be used as dopant for making n-type regions. A maximum doping concentrations of the drain region may lie in a range between 1·10¹⁷ cm⁻³ and 5·10²⁰ cm⁻³.

In a subsequent step S2, an epi-layer 11 is grown on the substrate 41, as still shown in Figure 3. In the described example, an n-type SiC epi-layer may be grown on the substrate 41. The epi-layer 11 may correspond to a drift layer in the finished power transistor 40. Depending on the voltage class of the power transistor 40, a maximum doping concentration of the drift layer may be in a range between 1·10¹⁴ cm⁻³ and 1·10¹⁷ cm⁻³.

Referring next to Figure 4, a photolithographic mask (not shown) may be formed on an upper surface 12 of the epi-layer 11 to selectively cover parts of the upper surface 12, before in a step S3 a remaining part of the surface 12 is doped using an appropriate dopant to form a well region 13. For example, Aluminum (Al), Boron (B) or Gallium (Ga) species, or any combination of the above, with or without n-type dopants, may be implanted to form a p-type well. That is to say, p-type regions may be formed by implantation of Al or B or Ga, but also by co-implanting Al/B, Al/Ga, B/Ga, or even by implanting Al/N, B/N etc. A maximum doping concentrations of the well region 13 may be 1·10¹⁶ cm⁻³ or above.

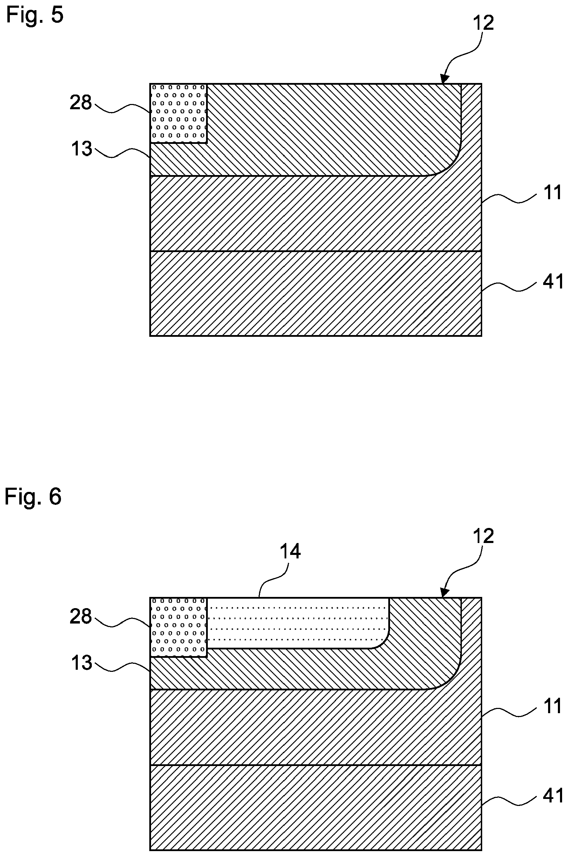

Referring next to Figure 5, in an optional step S4, a modified or new mask may be used to form a well contact region 28. The well contact region 28 may be a p++-doped area. A maximum doping concentrations of the well contact region 28 may lie in a range between 1·10¹⁷ cm⁻³ and 5·10²⁰ cm⁻³. In the finished power transistor 40, the well contact region 28 may prevent a floating of the electrical potential of the well region 13 during operation of the transistor device.

Referring next to Figure 6, in a step S5, a terminal region 14 may be formed using yet another photolithographic mask. For example, a highly doped n++ region may be formed within the p-well region 13 to form a source region of the power transistor 40. A maximum doping concentrations of the source region may lie in a range between 1·10¹⁷ cm⁻³ and 5·10²⁰ cm⁻³. The terminal region 14 shown in Figure 6 may be formed by implantation of nitrogen (N) or phosphorus (P) into the SiC base material.

Then, in a further step S6, the dopant species implanted in step S5 may be activated. For example, the implanted dopants may be activated at a relatively high temperature, e.g. for 30 minutes at a temperature of 1600 °C.

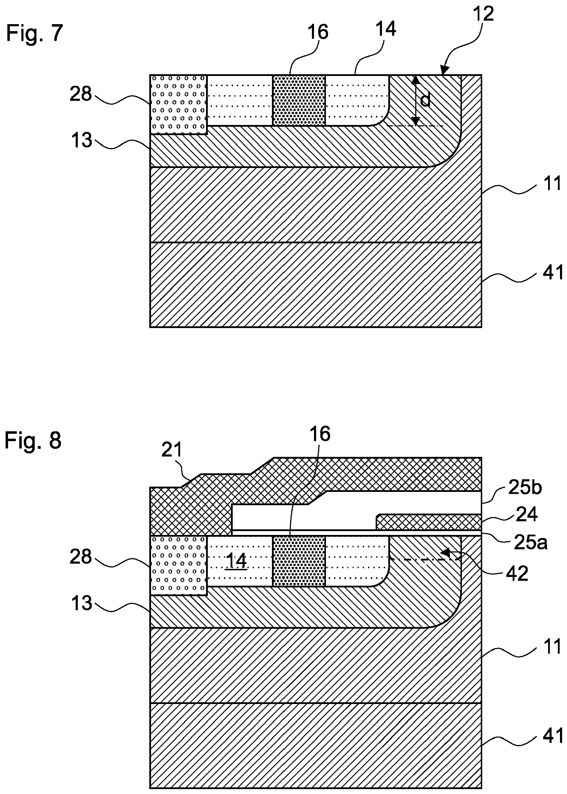

Referring next to Figure 7, in a further step S7 an amphoteric dopant is implanted in at least part of the terminal region 14 to form a resistive region 16. This may be achieved using another photolithographic mask (not shown). The SiC material of the epi-layer 11 is doped through one or more openings in the mask using an amphoteric dopant species. In accordance with the claimed invention Mn is used as the dopant species. V can be used as additional dopant. It is outside the scope of the claimed invention that in certain situations other amphoteric dopants may be used.

For example, ion implantation and/or plasma ion implantation may be used. Step S7 may be performed at room temperature with implantation energy chosen so that the depth d of the implanted amphoteric impurities matches the depths of the terminal region 14 as shown in Figure 7. Alternatively, a lower implantation energy may be used to result in a shallower implantation of amphoteric impurities.

The introduction of amphoteric impurities greatly increases the resistivity of the terminal region 14 within the resistive region 16. For example, an initial resistivity ρ of approximately 0.02 Qcm of an n++ source region may be increased by doping it with Mn or V to obtain an initial resistivity of about 20 kQcm. The presence of the deep Mn or V acceptor and donor levels in the respective upper and lower part of the SiC bandgap compensates the N donor or Al acceptor doping of the surrounding wide bandgap semiconductor material. The table below shows the location of the acceptor and donor levels of Mn and V with respect to the conduction band energy E_{C} and the valence band energy E_{V}.

| Dopant species | Donor level | Acceptor level |
|---|---|---|
| Mn | E_{C} - 1.38 eV | E_{C} - 0.68 eV |
| V | E_{C} - 1.47 eV | E_{C} - 0.70 eV |

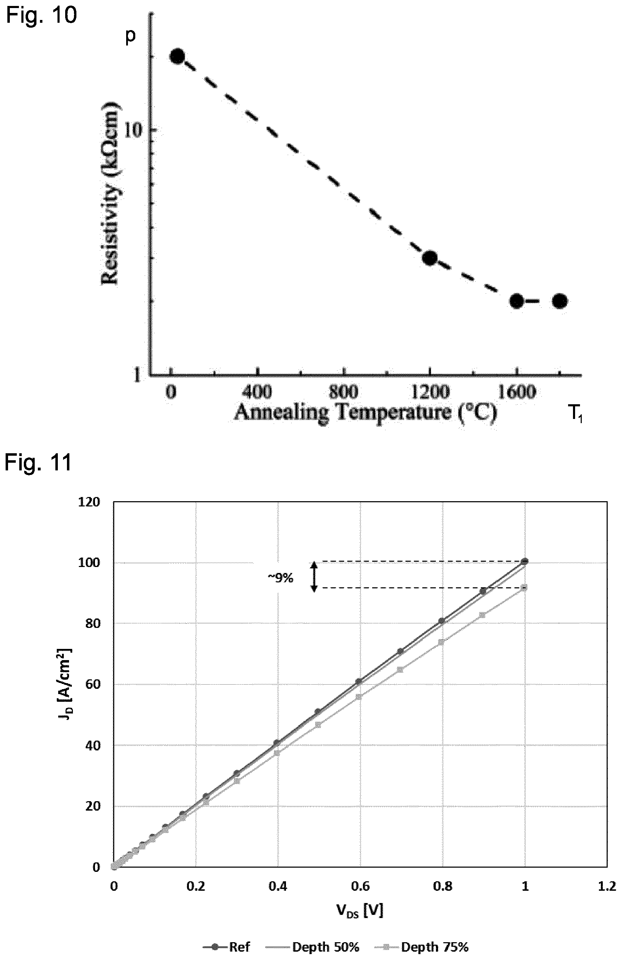

Among others, the use of amphoteric dopants allows the resistivity ρ of the resistive region 16 to be closely controlled in an optional annealing step S8. As shown in the logarithmic chart of Figure 10, the resistivity ρ of the resistive region 16 can be controlled by selection of a corresponding annealing temperature T₁.

Without annealing, the resistivity ρ initially lies at about 20 kQcm. With increasing annealing temperature T₁, applied for a given period of time, for example for 30 minutes, the resistivity ρ can be reduced to about 2 kQcm in the sample structure tested. Attention is drawn to the fact that the resistance of the terminal region 14 also depends on the implantation dose used during implantation of the amphoteric impurities. Thus, the resistance of the terminal region 14 may be controlled by at least two parameters during the manufacturing of the power transistor 40.

Referring next to Figure 8, in a further step S9, one or more insulation layers and/or electrodes may be formed on the upper surface 12 of the epi-layer 11.

In the configuration shown in Figure 8, at first an insulation layer 25a was formed over parts of the terminal region 14, the part of the well region 13 near the upper surface 12 later forming a channel region 42 of the transistor structure (dashed in Figure 8), as well as a neighbouring area of the epi-layer 11. On top of the first insulation layer 25a, a gate electrode 24 is formed. The gate electrode 24 is then covered by a second insulation layer 25b, which insulates a top surface of the gate electrode 24.

Thereafter, a source electrode 21 is formed on the remaining part of the upper surface 12 of the epi-layer 11 in the area of the well contact region 28 and parts of the terminal region 14. As shown in Figure 8, the source electrode 21 also covers an upper surface of the second insulation layer 25b, as is commonly the case in vertical power transistors 40.

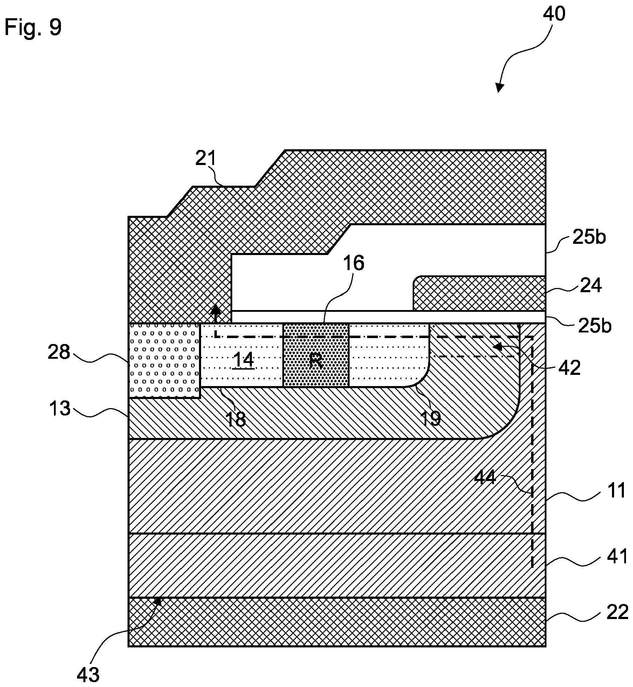

Figure 9 shows a cross-section through part of the finished vertical power transistor 40 after formation of a drain electrode 22 on an opposite back side 43 of the substrate 41.

Figure 9 also shows a current path 44 from the drain electrode 22, through the substrate 41, a drift layer formed by the epi-layer 11, the p-well region 13, including the channel region 42 (dashed), the terminal region 14, comprising two different n++ sub-regions 18, 19 without amphoteric dopants and another sub-region in the form of the resistive region 16, to the source electrode 21. By modulating the resistivity ρ of the resistive region 16 and hence of the terminal region 14, a short circuit current can be controlled without overly increasing the total source-to-drain resistance RDSon during normal operation.

Technology computer-aided design (TCAD) simulations have been used to prove the proposed solution; the results are shown in Figures 11 to 13.

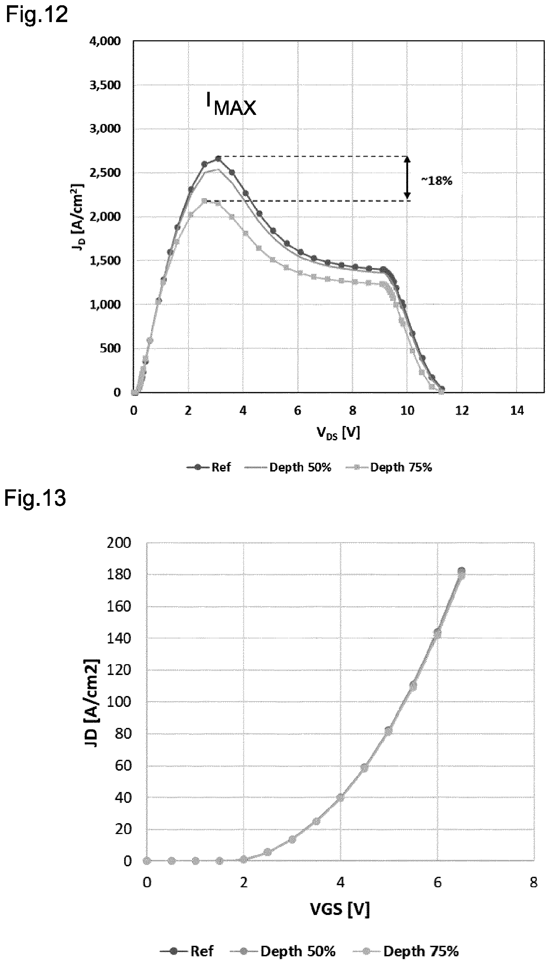

In particular, Figure 11 shows, in a linear chart, the J_{D}/V_{DS} characteristics of the power transistor 40, and Figure 12 shows, in a linear chart, the simulated electro-thermal short-circuit current density waveform J_{D} over time t. It can be seen that, compared to a reference design without the additional amphoteric implantation, the RDSon increases by about 9% (Figure 11), while the peak of the SC current is reduced by approximately 18% (Figure 12). Therefore the trade-off between conduction losses and SCWT is improved.

In general, during a short-circuit condition, a semiconductor device experiences an energy which is directly related to the maximum value of the current I_{MAX}. As shown in Figures 11 and 12, the disclosed design improves the SCWT with a minimal impact of the source-to-drain resistivity RDSon. The reduction of maximum or peak current I_{MAX} is due to the presence of the implanted amphoteric impurities in the resistive region 16. Since the implantation is performed in the source region, it does not affect the channel region 42.

Figure 13 shows, in a linear chart, the transfer characteristics of the power transistor 40. Attention is drawn to the fact that characteristics of the power transistor 40 with different depths d of a resistive region coincide for the characteristic J_{D}/V_{GS} curve of the reference design without amphoteric dopants, confirming that the threshold voltage value is not affected.

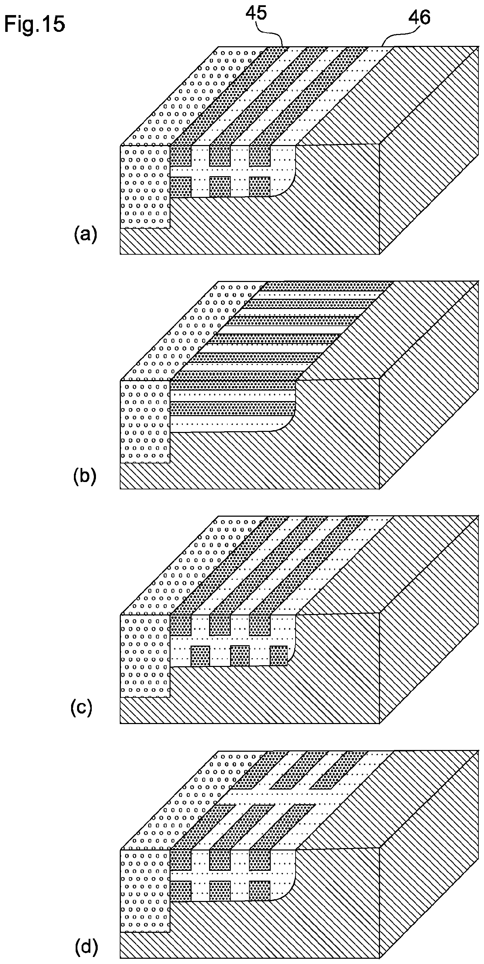

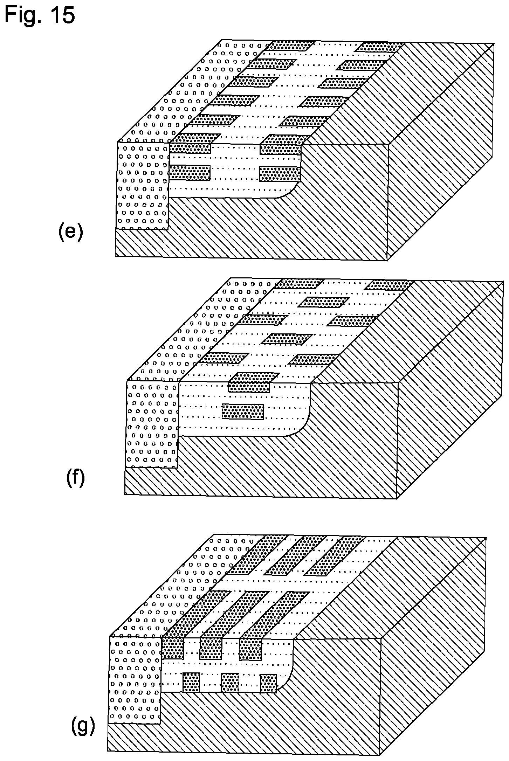

Figures 14 and 15 show various configurations of a terminal region 14 with one or more resistive regions 16 formed therein. Attention is drawn to the fact that amphoteric impurities do not diffuse in the used wide bandgap semiconductor material and thereby stay localized in the resistive regions 16 after doping. Thus, by using conventional doping techniques, different patterns can be achieved as shown.

For example, as an alternative to the vertical segmentation shown in Figure 7, a horizontal segmentation shown in Figure 14 (a) may be used. For example, a single resistive region 16 may be formed as shown in Figure 14 (a), or multiple resistive regions 16 separated by intermediate parts of the terminal region 14 not implanted with amphoteric impurities as shown in Figure 14 (b) may be used. Moreover, due to the selection of implantation energies, individual parts of the resistive region 16 can be located at an upper surface 12 or embedded deeper in the terminal region as shown, for example, to generate a chessboard pattern as shown in Figure 14 (c) or separated islands of amphoteric dopants as shown in Figure 14 (d). Of course, a vertical separation as already explained above with regard to Figure 7 can also comprise multiple resistive regions 16 as shown in Figure 14 (e).

Figures 15 (a) to 15 (g) show the formation of various first (darker) sub-regions 45 of the terminal region 14 doped with amphoteric impurities and second (lighter) sub-regions 46 of the terminal region 14 essentially free of amphoteric impurities. Such designs may be obtained, for example, by suitable masks or interference patterns used during implantation of the amphoteric species or a combination thereof.

The dimensions and implementation depths d and resistivity of the resistive regions 16 can be adjusted to extend along the entire depths of the terminal region 14 by varying the implantation energy within the range of, for example, 50 to 500 keV and/or by adjusting the doses, for example in the range of 10¹¹ to 10¹⁴ cm⁻².

The disclosed transistor structures and manufacturing techniques result in a number of benefits. This includes the modulation of the resistivity ρ of a terminal region 14, such as a source region, in order to adjust and control the trade-off between conduction losses and SCWT. Moreover, amphoteric impurities can be implanted irrespective of used base material, such as those used for forming and doping an n++ or p++ source or drain region. This enables, among others, that the implantation energy of the chosen amphoteric species can remain the same, irrespective of the dopant used for doping a corresponding terminal region, such as N, P, Al or B.

The embodiments shown in Figures 1 to 16 as stated represent exemplary embodiments of an improved transistor structure and method for its manufacturing. Therefore, they do not constitute a complete list of all embodiments according to the improved devices and/or methods. Actual devices, systems and methods may vary from the embodiments shown in terms of the semiconductor base materials, dopants, and processing parameters, for example.

### Reference Signs

- 10: transistor
- 11: epitaxial layer
- 12: upper surface
- 13: well region
- 14: terminal region
- 15: terminal electrode
- 16: resistive region
- 17: connecting part
- 18: left sub-region
- 19: right sub-region
- 20: VDMOS
- 21: source electrode
- 22: drain electrode
- 23: semiconductor transistor structure
- 24: gate electrode
- 25: insulation layer
- 26: substrate layer
- 27: drift layer
- 28: well contact region
- 29: source region
- 30: trench gate power transistor
- 40: power transistor
- 41: substrate
- 42: channel area
- 43: back side
- 44: current path
- 45: first sub-region (amphoteric)
- 46: second sub-region (non-amphoteric)

## Claims

1. A transistor (10), in particular a wide bandgap semiconductor power transistor (40), comprising:
- an epitaxial layer (11) of a first conductivity type;
- at least one well region (13) of a second conductivity type formed in a selected area of the epitaxial layer (11);
- at least one terminal region (14), in particular a source region (29), of the first conductivity type formed in or adjacent to the at least one well region (13);
- at least one terminal electrode (15), in particular a source electrode (21), formed at least partly on a surface (12) of a first part of the at least one terminal region (14); and
- at least one resistive region (16) formed within the at least one terminal region (14), the at least one resistive region (16) comprising Manganese, Mn, as amphoteric dopant.

2. The transistor (10) of claim 1, wherein the at least one resistive region (16) further comprises Vanadium, V, as amphoteric dopant.

3. The transistor (10) of claim 1 or 2, wherein a concentration of amphoteric dopants in the at least one resistive region (16) lies in the range of 10¹⁴ to 10¹⁸ cm⁻³.

4. The transistor (10) of any one of claims 1 to 3, wherein
- a resistivity ρ of the terminal region (14) exceeds 10 Qcm, and preferably lies in the range of 20Ωcm to 20 kQcm.

5. The transistor (10) of any one of claims 1 to 4, wherein a short-circuit withstand time, SCWT, of the transistor exceeds 3 ps, and preferably is or exceeds 10 µs.

6. The transistor (10) of any one of claims 1 to 5, wherein
- a depth d of the at least one resistive region (16) lies in the range of 0 to 100%, preferably in the range of 10% to 100%, of the maximal thickness of the at least one terminal region (14).

7. The transistor (10) of any one of claims 1 to 6, wherein the at least one terminal region (14) comprises three sub-regions, comprising one first sub-region comprising amphoteric impurities arranged horizontally between and/or separating two adjacent second sub-regions essentially free of amphoteric impurities.

8. The transistor (10) of any one of claims 1 to 6, wherein the at least one terminal region (14) comprises at least three sub-regions, comprising at least one first sub-region (45) comprising amphoteric impurities and at least one second sub-region (18, 19, 46) essentially free of amphoteric impurities, in particular one of:
- one first sub-region (45) arranged vertically between and/or separating two adjacent second sub-regions (46);
- a plurality of first sub-regions (45) partially or completely embedded as resistive islands in a common second sub-region (46); and
- a first plurality of first sub-regions (45) and a second plurality of second sub-regions (46) forming at least one of a horizontal grid, a vertical grid, a comb structure, and a chess-board pattern.

9. The transistor (10) of any one of claims 1 to 8, wherein the transistor (10) is one of a metal-oxide-semiconductor field-effect transistor, MOSFET, a metal-insulator-semiconductor field-effect transistor, MISFET, a junction field-effect transistor, JFET, and an insulated-gate bipolar transistor, IGBT, in one of a planar or a trench configuration.

10. The transistor (10) of any one of claims 1 to 9, wherein the transistor (10) is a vertical power transistor (40), comprising:
- a substrate (41) of the first conductivity type carrying the epitaxial layer (11) on a first side;
- a drain electrode (22) formed on an opposite back side (43) of the substrate (41); and
- at least one channel region (42) formed within the at least one well region (13) in proximity to a gate structure (23),
- wherein the at least one terminal region (14) forms a source region (29), the epitaxial layer (11) forms a drift region, and the substrate (41) forms a drain region of the vertical power transistor (40).

11. The transistor (10) of any one of claims 1 to 9, further comprising at least one of the following:
- at least one highly doped well contact region (28) of the second conductivity type, electrically connecting the at least one well region (13) with the at least one terminal electrode (15);
- a second terminal region and a second electrode formed at least partly on a surface of the second terminal region; and
- a first insulation layer (25a) formed on a surface (12) of the epitaxial layer (11) and a gate electrode (24) formed on a surface of the first insulation layer (25a).

12. The transistor (10) of any one of claims 1 to 11, wherein the epitaxial layer (11) is formed from n-type silicon carbide, SiC.

13. A power electronic switching device, comprising a plurality of transistor cells arranged on a common substrate and/or electrically connected in parallel, each transistor cell comprising a transistor (10) according to one of claims 1 to 9.

14. A method for manufacturing a transistor (10), in particular a wide bandgap semiconductor power transistor (40), comprising:
- epitaxially growing (S2) a semiconductor layer of a first conductivity type;
- forming (S3) at least one well region (13) of a second conductivity type formed in a selected area of the epitaxial layer (11);
- forming (S5) at least one terminal region (14), in particular a source region (29), of the first conductivity type in or adjacent to the at least one well region (13); and
- implanting (S7) Manganese, Mn, as an amphoteric dopant in at least a part of the at least one terminal region (14) to form at least one resistive region (16).

15. The method of claim 14, wherein the amphoteric dopant is implanted using an implantation energy in the range of 50 to 1000 keV.

16. The method of claim 14 or 15, wherein the amphoteric dopant is implanted using an implantation dose in the range of 10¹⁰ cm⁻² to 10¹⁴ cm⁻².

17. The method of any one of claims 14 to 16, further comprising:
- annealing (S8) the at least one resistive region (16) comprising the implanted amphoteric dopants at a first temperature T₁, wherein the first temperature T₁ is selected based on a target resistivity ρ of the terminal region (14) .

18. The method of claim 17, further comprising:
- prior to annealing (S8) the at least one resistive region (16), activating (S6) the at least one terminal region (14) at a second temperature T₂ exceeding the first temperature T₁; and/or
- after implanting (S7) the amphoteric dopant, forming (S9) at least one terminal electrode (15), in particular a source electrode (21), at least partly on a surface (12) of at least part of the at least one terminal region 16).

## Patentansprüche

1. Transistor (10), insbesondere ein Halbleiterleistungstransistor mit breiter Bandlücke (40), Folgendes umfassend:
- eine epitaxiale Schicht (11) eines ersten Leitfähigkeitstyps;
- mindestens einen Wannenbereich (13) eines zweiten Leitfähigkeitstyps, der in einem ausgewählten Gebiet der epitaxialen Schicht (11) ausgebildet ist;
- mindestens einen Anschlussbereich (14), insbesondere einen Source-Bereich (29), des ersten Leitfähigkeitstyps, der in dem mindestens einen Wannenbereich (13) oder dazu benachbart ausgebildet ist;
- mindestens eine Anschlusselektrode (15), insbesondere eine Source-Elektrode (21), die mindestens teilweise auf einer Oberfläche (12) eines ersten Teils des mindestens einen Anschlussbereichs (14) ausgebildet ist; und
- mindestens einen ohmschen Bereich (16), der innerhalb des mindestens einen Anschlussbereichs (14) ausgebildet ist, wobei der mindestens eine ohmsche Bereich (16) Mangan, Mn, als amphoteren Dotierstoff umfasst.

2. Transistor (10) nach Anspruch 1, wobei der mindestens eine ohmsche Bereich (16) weiterhin Vanadium, V, als amphoteren Dotierstoff umfasst.

3. Transistor (10) nach Anspruch 1 oder 2, wobei eine Konzentration amphoterer Dotierstoffe in dem mindestens einen ohmschen Bereich (16) zwischen 10¹⁴ und 10¹⁸ cm⁻³ liegt.

4. Transistor (10) nach einem der Ansprüche 1 bis 3, wobei
- ein spezifischer Widerstand ρ des Anschlussbereichs (14) 10 Qcm übersteigt und vorzugsweise zwischen 20 Qcm und 20 kQcm liegt.

5. Transistor (10) nach einem der Ansprüche 1 bis 4, wobei eine Kurzschlusswiderstandszeit, SCWT, des Transistors 3 us übersteigt und vorzugsweise 10 µs beträgt oder übersteigt.

6. Transistor (10) nach einem der Ansprüche 1 bis 5, wobei
- eine Tiefe d des mindestens einen ohmschen Bereichs (16) zwischen 0 und 100 %, vorzugsweise zwischen 10 % und 100 %, der maximalen Dicke des mindestens einen Anschlussbereichs (14) liegt.

7. Transistor (10) nach einem der Ansprüche 1 bis 6, wobei der mindestens eine Anschlussbereich (14) drei Teilbereiche umfasst, die einen ersten Teilbereich umfassen, der amphotere Fremdstoffe umfasst, die horizontal zwischen zwei benachbarten zweiten Teilbereichen angeordnet sind und/oder diese trennen, die im Wesentlichen frei von amphoteren Fremdstoffen sind.

8. Transistor (10) nach einem der Ansprüche 1 bis 6, wobei der mindestens eine Anschlussbereich (14) mindestens drei Teilbereiche umfasst, die mindestens einen ersten Teilbereich (45), der amphotere Fremdstoffe umfasst, und mindestens einen zweiten Teilbereich (18, 19, 46) umfassen, der im Wesentlichen frei von amphoteren Fremdstoffen ist, insbesondere einer der folgenden:
- einen ersten Teilbereich (45), der vertikal zwischen zwei benachbarten zweiten Teilbereichen (46) angeordnet ist und/oder diese trennt;
- eine Vielzahl von ersten Teilbereichen (45), die teilweise oder vollständig als ohmsche Inseln in einem gemeinsamen zweiten Teilbereich (46) eingebettet sind; und
- eine erste Vielzahl erster Teilbereiche (45) und eine zweite Vielzahl zweiter Teilbereiche (46), die mindestens eines von einem horizontalen Gitter, einem vertikalen Gitter, einer Kammstruktur und einem Schachbrettmuster ausbilden.

9. Transistor (10) nach einem der Ansprüche 1 bis 8, wobei der Transistor (10) einer von einem Metalloxid-Halbleiter-Feldeffekttransistor, MOSFET, einem Metall-Isolator-Halbleiter-Feldeffekttransistor, MISFET, einem Sperrschicht-Feldeffekttransistor, JFET, oder einem Bipolartransistor mit isoliertem Gate, IGBT, in einer Planar- oder einer Grabenkonfiguration ist.

10. Transistor (10) nach einem der Ansprüche 1 bis 9, wobei der Transistor (10) ein vertikaler Leistungstransistor (40) ist, Folgendes umfassend:
- ein Substrat (41) des ersten Leitfähigkeitstyps, das die epitaxiale Schicht (11) auf einer ersten Seite trägt;
- eine Drain-Elektrode (22), die auf einer gegenüberliegenden Rückseite (43) des Substrats (41) ausgebildet ist; und
- mindestens einen Kanalbereich (42), der innerhalb des mindestens einen Wannenbereichs (13) in der Nähe einer Gate-Struktur (23) ausgebildet ist,
- wobei der mindestens eine Anschlussbereich (14) einen Source-Bereich (29) ausbildet, die epitaxiale Schicht (11) einen Driftbereich ausbildet und das Substrat (41) einen Drain-Bereich des vertikalen Leistungstransistors (40) ausbildet.

11. Transistor (10) nach einem der Ansprüche 1 bis 9, weiterhin mindestens eines des Folgenden umfassend:
- mindestens einen hochdotierten Wannenkontaktbereich (28) des zweiten Leitfähigkeitstyps, der den mindestens einen Wannenbereich (13) mit der mindestens einen Anschlusselektrode (15) elektrisch verbindet;
- einen zweiten Anschlussbereich und eine zweite Elektrode, die mindestens teilweise auf einer Oberfläche des zweiten Anschlussbereichs ausgebildet ist; und
- eine erste Isolationsschicht (25a), die auf einer Oberfläche (12) der epitaxialen Schicht (11) ausgebildet ist, und eine Gate-Elektrode (24), die auf einer Oberfläche der ersten Isolationsschicht (25a) ausgebildet ist.

12. Transistor (10) nach einem der Ansprüche 1 bis 11, wobei die epitaxiale Schicht (11) aus n-leitendem Siliziumcarbid, SiC, ausgebildet ist.

13. Leistungselektronische Schaltvorrichtung, eine Vielzahl von Transistorzellen umfassend, die auf einem gemeinsamen Substrat angeordnet sind und/oder elektrisch parallel geschaltet sind, wobei jede Transistorzelle einen Transistor (10) nach einem der Ansprüche 1 bis 9 umfasst.

14. Verfahren zum Herstellen eines Transistors (10), insbesondere eines Halbleiterleistungstransistors mit breiter Bandlücke (40), Folgendes umfassend:
- epitaxiales Aufwachsen (S2) einer Halbleiterschicht eines ersten Leitfähigkeitstyps;
- Ausbilden (S3) mindestens eines Wannenbereichs (13) eines zweiten Leitfähigkeitstyps, der in einem ausgewählten Gebiet der epitaxialen Schicht (11) ausgebildet ist;
- Ausbilden (S5) mindestens eines Anschlussbereichs (14), insbesondere eines Source-Bereichs (29), des ersten Leitfähigkeitstyps in dem mindestens einen Wannenbereich (13) oder dazu benachbart;
- Implantieren (S7) von Mangan, Mn, als einen amphoteren Dotierstoff in mindestens einen Teil des mindestens einen Anschlussbereichs (14), um mindestens einen ohmschen Bereich (16) auszubilden.

15. Verfahren nach Anspruch 14, wobei der amphotere Dotierstoff unter Verwendung einer Implantationsenergie im Bereich von 50 bis 1000 keV implantiert wird.

16. Verfahren nach Anspruch 14 oder 15, wobei der amphotere Dotierstoff unter Verwendung einer Implantationsdosis im Bereich von 10¹⁰ cm⁻² bis 10¹⁴ cm⁻². implantiert wird.

17. Verfahren nach einem der Ansprüche 14 bis 16, weiterhin Folgendes umfassend:
- Tempern (S8) des mindestens einen ohmschen Bereichs (16), der die implantierten amphoteren Dotierstoffe umfasst, bei einer ersten Temperatur T₁, wobei die erste Temperatur T₁ auf der Grundlage eines zu erzielenden spezifischen Widerstands ρ des Anschlussbereichs (14) ausgewählt ist.

18. Verfahren nach Anspruch 17, weiterhin Folgendes umfassend:
- vor dem Tempern (S8) des mindestens einen ohmschen Bereichs (16) Aktivieren (S6) des mindestens einen Anschlussbereichs (14) bei einer zweiten Temperatur T₂, welche die erste Temperatur T₁ übersteigt; und/oder
- nach Implantieren (S7) des amphoteren Dotierstoffs, Ausbilden (S9) mindestens einer Anschlusselektrode (15), insbesondere einer Source-Elektrode (21), mindestens teilweise auf einer Oberfläche (12) mindestens eines ersten Teils des mindestens einen Anschlussbereichs (16).

## Revendications

1. Transistor (10), en particulier transistor de puissance à semi-conducteurs à large bande interdite (40), comprenant :
- une couche épitaxiale (11) d'un premier type de conductivité ;
- au moins une région de puits (13) d'un deuxième type de conductivité formée dans une zone sélectionnée de la couche épitaxiale (11) ;
- au moins une région de borne (14), en particulier une région de source (29), du premier type de conductivité formée dans ou au voisinage de l'au moins une région de puits (13) ;
- au moins une électrode de borne (15), en particulier une électrode de source (21), formée au moins partiellement sur une surface (12) d'une première partie de l'au moins une région de borne (14) ; et
- au moins une région résistive (16) formée à l'intérieur de l'au moins une région de borne (14), l'au moins une région résistive (16) comprenant du manganèse, Mn, comme dopant amphotère.

2. Transistor (10) selon la revendication 1, dans lequel l'au moins une région résistive (16) comprend en outre du vanadium, V, comme dopant amphotère.

3. Transistor (10) selon la revendication 1 ou 2, dans lequel une concentration de dopants amphotères dans l'au moins une région résistive (16) se situe dans la plage de 10¹⁴ à 10¹⁸ cm⁻³.

4. Transistor (10) selon l'une quelconque des revendications 1 à 3, dans lequel
- une résistivité ρ de la région de borne (14) dépasse 10 Qcm, et de préférence se situe dans la plage de 20 Qcm à 20 kQcm.

5. Transistor (10) selon l'une quelconque des revendications 1 à 4, un temps de tenue aux courts-circuits, SCWT, du transistor dépassant 3 µs, et de préférence étant égal ou supérieur à 10 us.

6. Transistor (10) selon l'une quelconque des revendications 1 à 5, dans lequel
- une profondeur d de l'au moins une région résistive (16) se situe dans la plage de 0 à 100 %, de préférence dans la plage de 10 % à 100 %, de l'épaisseur maximale de l'au moins une région de borne (14).

7. Transistor (10) selon l'une quelconque des revendications 1 à 6, dans lequel l'au moins une région de borne (14) comprend trois sous-régions, comprenant une première sous-région comprenant des impuretés amphotères disposée horizontalement entre et/ou séparant deux deuxièmes sous-régions adjacentes essentiellement dépourvues d'impuretés amphotères.

8. Transistor (10) selon l'une quelconque des revendications 1 à 6, dans lequel l'au moins une région de borne (14) comprend au moins trois sous-régions, comprenant au moins une première sous-région (45) comprenant des impuretés amphotères et au moins une deuxième sous-région (18, 19, 46) essentiellement dépourvue d'impuretés amphotères, en particulier :
- soit une première sous-région (45) disposée verticalement entre et/ou séparant deux deuxièmes sous-régions (46) adjacentes ;
- soit une pluralité de premières sous-régions (45) partiellement ou complètement incorporées sous forme d'îlots résistifs dans une deuxième sous-région commune (46) ;
- soit une première pluralité de premières sous-régions (45) et une deuxième pluralité de deuxièmes sous-régions (46) formant au moins un élément parmi une grille horizontale, une grille verticale, une structure de peigne, et un motif de damier.

9. Transistor (10) selon l'une quelconque des revendications 1 à 8, le transistor (10) étant soit un transistor à effet de champ métal-oxyde-semi-conducteur, MOSFET, soit un transistor à effet de champ métal-isolant-semi-conducteur, MISFET, soit un transistor à effet de champ à jonction, JFET, soit un transistor bipolaire à grille isolée, IGBT, dans une configuration soit planaire, soit en tranchées.

10. Transistor (10) selon l'une quelconque des revendications 1 à 9, le transistor (10) étant un transistor de puissance vertical (40), comprenant :
- un substrat (41) du premier type de conductivité portant la couche épitaxiale (11) sur un premier côté ;
- une électrode de drain (22) formée sur un côté arrière opposé (43) du substrat (41) ; et
- au moins une région de canal (42) formée à l'intérieur de l'au moins une région de puits (13) à proximité d'une structure de grille (23),
- dans lequel l'au moins une région de borne (14) forme une région de source (29), la couche épitaxiale (11) forme une région de dérive, et le substrat (41) forme une région de drain du transistor de puissance vertical (40).

11. Transistor (10) selon l'une quelconque des revendications 1 à 9, comprenant en outre au moins un des éléments suivants :
- au moins une région de contact de puits fortement dopée (28) du deuxième type de conductivité, reliant électriquement l'au moins une région de puits (13) à l'au moins une électrode de borne (15) ;
- une deuxième région de borne et une deuxième électrode formée au moins partiellement sur une surface de la deuxième région de borne ; et
- une première couche d'isolation (25a) formée sur une surface (12) de la couche épitaxiale (11) et une électrode de grille (24) formée sur une surface de la première couche d'isolation (25a).

12. Transistor (10) selon l'une quelconque des revendications 1 à 11, dans lequel la couche épitaxiale (11) est formée à partir de carbure de silicium, SiC, de type n.

13. Dispositif de commutation électronique de puissance, comprenant une pluralité de cellules de transistor disposées sur un substrat commun et/ou reliées électriquement en parallèle, chaque cellule de transistor comprenant un transistor (10) selon une des revendications 1 à 9.

14. Procédé de fabrication d'un transistor (10), en particulier d'un transistor de puissance à semi-conducteurs à large bande interdite (40), comprenant :
- la croissance épitaxiale (S2) d'une couche semiconductrice d'un premier type de conductivité ;
- la formation (S3) d'au moins une région de puits (13) d'un deuxième type de conductivité formée dans une zone sélectionnée de la couche épitaxiale (11) ;
- la formation (S5) d'au moins une région de borne (14), en particulier d'une région de source (29), du premier type de conductivité dans ou au voisinage de l'au moins une région de puits (13) ; et
- l'implantation (S7) de manganèse, Mn, comme dopant amphotère dans au moins une partie de l'au moins une région de borne (14) pour former au moins une région résistive (16) .

15. Procédé selon la revendication 14, dans lequel le dopant amphotère est implanté au moyen d'une énergie d'implantation dans la plage de 50 à 1000 keV.

16. Procédé selon la revendication 14 ou 15, dans lequel le dopant amphotère est implanté au moyen d'une dose d'implantation dans la plage de 10¹⁰ cm⁻² à 10¹⁴ cm⁻².

17. Procédé selon l'une quelconque des revendications 14 à 16, comprenant en outre :
- le recuit (S8) de l'au moins une région résistive (16) comprenant les dopants amphotères implantés à une première température T₁, la première température T₁ étant sélectionnée sur la base d'une résistivité cible ρ de la région de borne (14).

18. Procédé selon la revendication 17, comprenant en outre :
- avant le recuit (S8) de l'au moins une région résistive (16), l'activation (S6) de l'au moins une région de borne (14) à une deuxième température T₂ dépassant la première température T₁ ; et/ou
- après l'implantation (S7) du dopant amphotère, la formation (S9) d'au moins une électrode de borne (15), en particulier d'une électrode de source (21), au moins partiellement sur une surface (12) d'au moins une partie de l'au moins une région de borne (16).
